# EUROPEAN PATENT APPLICATION

(11) **EP 4 289 994 A1**
(43) Date of publication of application: **13.12.2023**
(21) Application number: 22749449.9
(22) Date of filing: 17.01.2022
(51) Int. Cl.: C30B 25/18, H01L 21/20, H01L 21/205, C30B 29/38

(54) **NITRIDE SEMICONDUCTOR SUBSTRATE AND METHOD FOR PRODUCING SAME**

(30) Priority: 05.02.2021 JP 2021017688
(71) Applicant: Shin-Etsu Handotai Co., Ltd., Tokyo 100-0004 (JP)
(72) Inventor: KUBONO, Ippei, Annaka-shi, Gunma 379-0196 (JP); HAGIMOTO, Kazunori, Annaka-shi, Gunma 379-0196 (JP); SHINOMIYA, Masaru, Annaka-shi, Gunma 379-0196 (JP)
(74) Representative: Sonnenhauser, Thomas Martin
(86) International application number: PCT/JP2022/001273
(87) International publication number: WO 2022/168572

(57) **Abstract**

The present invention is a nitride semiconductor substrate, including a Ga-containing nitride semiconductor thin film formed on a substrate for film-forming in which a single crystal silicon layer is formed on a composite substrate in which a plurality of layers is bonded, wherein the nitride semiconductor substrate has a region where the Ga-containing nitride semiconductor thin film is not formed inward from an edge of the single crystal silicon layer being a growth surface of the nitride semiconductor thin film. This provides: a nitride semiconductor substrate with inhibited generation of a reaction mark; and a manufacturing method therefor.

## Description

### TECHNICAL FIELD

The present invention relates to a nitride semiconductor substrate and a manufacturing method therefor.

### BACKGROUND ART

A MOCVD method, which is one of methods for manufacturing a semiconductor thin film is commonly used because the method has excellent large-diameter formability and mass productivity and can form a uniform thin film crystal. Nitride semiconductors represented by GaN are promising as a next-generation semiconductor material beyond the limit of a Si material. For a substrate for epitaxially growing GaN in the MOCVD method, GaN, SiC, sapphire, Si, etc. are used.

Among these, Si is most inexpensive and a substrate useful for large-diameter formability. However, since GaN and Si have difference in a thermal expansion coefficient, tensile stress is applied to GaN in a cooling step after the epitaxial film-formation. Thus, there are problems such as difficulty in forming a thick epitaxial layer, occurrence of cracking, and necessity of a complex stress-relaxing layer.

Since a GaN substrate has a thermal expansion coefficient same as (or extremely close to) that of the GaN epitaxial film, the above problems hardly occur. However, there are problems such as difficulty of producing a free-standing GaN substrate and its expensiveness, and unavailability of a substrate with a large diameter.

Thus, developed is a large-diameter substrate with a large diameter for growing the GaN epitaxial film, which has a thermal expansion coefficient close to that of GaN (hereinafter, "composite substrate for growing GaN"). This composite substrate for growing GaN is constituted with: a composite substrate having a polycrystalline ceramic core, a first adhesive layer bonded to an entirety of the polycrystalline ceramic core, a conductive layer bonded to an entirety of the first adhesive layer as necessary, a second adhesive layer bonded to an entirety of the conductive layer or to the entirety of the first adhesive layer, and a barrier layer bonded to an entirety of the second adhesive layer; a silicon oxide layer bonded to only one surface of the composite substrate; and a single crystal silicon layer bonded to the silicon oxide layer.

Using this composite substrate for growing GaN enables to produce a GaN epitaxial growth substrate that has a large diameter and a thick epitaxial layer and that causes no cracking. In addition, since the difference from GaN in the thermal expansion coefficient is small, the substrate is hardly warped in growing GaN or cooling, and a warp of the substrate after the film formation can be regulated to be small. Furthermore, since a large part of the composite substrate for growing GaN is made of ceramics, the substrate itself is extremely hard and hardly plastically deformed, and wafer breakage, which has not been solved with GaN/Si, does not occur.

However, both of the single crystal silicon substrate and the composite substrate for growing GaN have a surface (GaN growth surface) made of single crystal silicon, and thereby a eutectic reaction product (hereinafter, "reaction mark") between Si and Ga due to melt-back etching is likely to be generated. This reaction mark not only decreases a device yield but also probably becomes a dust source in a device process, which may contaminate a process line. Thus, it is extremely important to control generation of the reaction mark.

Accordingly, the generation of the reaction mark is basically prevented by using a layer such as AlN on the single crystal silicon substrate, but even in this case, the reaction mark may be generated on several positions in the wafer surface. Patent Document 1 discloses art for removing the reaction mark after the epitaxial growth of GaN, but does not disclose a method for controlling the reaction mark by making contrivance in the epitaxial growth.

Patent Documents 2 and 3 disclose art about forming a III-V group semiconductor thin film on the composite substrate for growing GaN, but do not describe a reduction in defects in the film formation. There has been no literature disclosing art about a reduction in defects in forming a semiconductor thin film on the composite substrate for growing GaN.

### CITATION LIST

### PATENT LITERATURE

Patent Document 1: JP 2015-170648 A
Patent Document 2: JP 2020-505767 A
Patent Document 3: JP 2019-523994 A

### SUMMARY OF INVENTION

### TECHNICAL PROBLEM

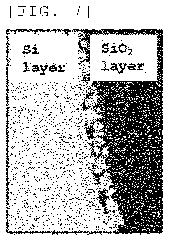

When GaN is epitaxially grown on the composite substrate for growing GaN as above, the single crystal silicon in a surface layer of the composite substrate for growing GaN and Ga in trimethylgallium (TMGa) used as a Ga source may be reacted to generate the reaction mark. Compared with GaN growth on the single crystal silicon substrate, GaN growth on the composite substrate for growing GaN tends to generate the reaction mark. This is because an edge of the surface layer of the single crystal silicon layer on the composite substrate for growing GaN, which has a complex shape (FIG. 7), causes a place where an AlN layer that is formed as an initial layer in forming the GaN epitaxial film is hardly formed, and a bare single crystal silicon is present on the edge of the single crystal silicon layer with a high possibility to be likely to allow Ga to be reacted with the single crystal silicon. An edge of the wafer and the edge of the single crystal silicon layer are not necessarily coincided, and the edge of the single crystal silicon layer is present inward within a certain range from the edge of the wafer in many cases. The position where the reaction mark is generated may not only decrease the device yield but also may become a dust source in a device process to contaminate the process, and thereby the reduction is required.

The present invention has been made to solve the above problem. An object of the present invention is to provide: a nitride semiconductor substrate with inhibited generation of the reaction mark; and a manufacturing method therefor.

### SOLUTION TO PROBLEM

To solve the above problem, the present invention provides a nitride semiconductor substrate comprising a Ga-containing nitride semiconductor thin film formed on a substrate for film-forming in which a single crystal silicon layer is formed on a composite substrate in which a plurality of layers is bonded, wherein the nitride semiconductor substrate has a region where the Ga-containing nitride semiconductor thin film is not formed inward from an edge of the single crystal silicon layer being a growth surface of the nitride semiconductor thin film.

Such a nitride semiconductor substrate can inhibit the generation of the reaction mark due to the eutectic reaction between the single crystal silicon and Ga.

In the present invention, the region where the film is not formed is preferably a region with 0.3 mm or longer and shorter than 3 mm inward from the edge of the single crystal silicon layer.

Such a nitride semiconductor substrate can more improve the effect of the present invention.

In the present invention, the single crystal silicon layer preferably has a thickness of 300 to 500 nm.

Such a nitride semiconductor substrate can further improve the effect of the present invention.

In the present invention, the nitride semiconductor thin film formed on the substrate for film-forming preferably has: an AlN film; and a GaN film or an AlGaN film, or a both thereof formed on the AlN film.

Such a nitride semiconductor substrate is useful as a nitride semiconductor substrate required in recent years, and can still further improve the effect of the present invention.

In the present invention, the substrate for film-forming is preferably constituted with: a composite substrate having a polycrystalline ceramic core, a first adhesive layer bonded to an entirety of the polycrystalline ceramic core, a conductive layer bonded to an entirety of the first adhesive layer as necessary, a second adhesive layer bonded to an entirety of the conductive layer or to the entirety of the first adhesive layer, and a barrier layer bonded to an entirety of the second adhesive layer; a silicon oxide layer bonded only on one surface of the composite substrate; and the single crystal silicon layer bonded to the silicon oxide layer.

The nitride semiconductor substrate using such a substrate for film-forming can regulate a warp of the substrate after the film formation to be small.

In the present invention, the polycrystalline ceramic core preferably contains aluminum nitride.

Such a nitride semiconductor substrate can regulate a warp of the substrate after the film formation to be smaller.

In the present invention, the first adhesive layer and the second adhesive layer preferably contain tetraethyl orthosilicate (TEOS) or silicon oxide (SiO₂), the conductive layer preferably has a polysilicon layer, and the barrier layer preferably contains silicon nitride.

Such a nitride semiconductor substrate can regulate the warp of the substrate after the film formation to be further smaller, and can form a thick nitride semiconductor thin film.

The present invention also provides a method for manufacturing a nitride semiconductor substrate, the method comprising steps of:
preparing at least a composite substrate in which a plurality of layers is bonded and a single crystal silicon substrate;
bonding the composite substrate and the single crystal silicon substrate via a silicon oxide layer;
thinning the single crystal silicon substrate to be processed into a single crystal silicon layer;
placing a ring-shaped member so as to cover the single crystal silicon layer inward from an edge thereof;
growing an AlN film on the single crystal silicon layer; and
growing a GaN film or an AlGaN film, or both thereof on the AlN film.

Such a method for manufacturing a nitride semiconductor substrate can relatively easily manufacture the nitride semiconductor substrate with inhibited generation of the reaction mark due to the eutectic reaction between the single crystal silicon and Ga.

In the present invention, the composite substrate in which the plurality of the layers is bonded is preferably a composite substrate having: a polycrystalline ceramic core; a first adhesive layer bonded to an entirety of the polycrystalline ceramic core; a conductive layer bonded to an entirety of the first adhesive layer as necessary; a second adhesive layer bonded to an entirety of the conductive layer or to the entirety of the first adhesive layer; and a barrier layer bonded to an entirety of the second adhesive layer.

Such a method for manufacturing a nitride semiconductor substrate can more improve the effect of the present invention.

### ADVANTAGEOUS EFFECTS OF INVENTION

As noted above, the inventive nitride semiconductor substrate can inhibit the generation of the reaction mark due to the eutectic reaction between the single crystal silicon and Ga. Therefore, a high-quality nitride semiconductor substrate can be obtained, and in manufacturing a device using this substrate, improvement of a device yield and higher precision can be attempted.

### BRIEF DESCRIPTION OF DRAWINGS

FIG. 1 is a schematic image of a top view illustrating an example of the inventive nitride semiconductor substrate.
FIG. 2 is a schematic image illustrating an example of an MOCVD apparatus that can be used for the inventive method for manufacturing a nitride semiconductor substrate.
FIG. 3 is a schematic sectional view illustrating an example of a substrate for film-forming of the inventive nitride semiconductor substrate.
FIG. 4 shows a relationship between a change in a width of A illustrated in FIG. 1 and a number of generated reaction marks.
FIG. 5 is an observation image with an optical microscope showing an edge portion of a substrate formed in Example.
FIG. 6 is an observation image with an optical microscope showing an edge portion of a substrate formed in Comparative Example.
FIG. 7 is an observation image with an optical microscope showing an edge of a surface layer of a single crystal silicon layer on a composite substrate for growing GaN.

### DESCRIPTION OF EMBODIMENTS

As noted above, there have been demands for development of a nitride semiconductor substrate with inhibited generation of the reaction mark and a manufacturing method therefor.

As noted above, when the Ga-containing nitride semiconductor is epitaxially grown on the composite substrate for growing GaN, the single crystal silicon in a surface layer of the composite substrate for growing GaN and Ga in trimethylgallium (TMGa) used as a Ga source may be reacted to generate the reaction mark. The present inventors have made earnest study to solve the above problem, and have found that the generation of the reaction mark can be inhibited by providing a region where the Ga-containing nitride semiconductor thin film is not formed inward from an edge of the single crystal silicon layer being a growth surface of the nitride semiconductor thin film. This finding has led to complete the present invention.

Specifically, the present invention is a nitride semiconductor substrate comprising a Ga-containing nitride semiconductor thin film formed on a substrate for film-forming in which a single crystal silicon layer is formed on a composite substrate in which a plurality of layers is bonded, wherein the nitride semiconductor substrate has a region where the Ga-containing nitride semiconductor thin film is not formed inward from an edge of the single crystal silicon layer being a growth surface of the nitride semiconductor thin film.

In addition, the present invention is a method for manufacturing a nitride semiconductor substrate, the method comprising steps of:
preparing at least a composite substrate in which a plurality of layers is bonded and a single crystal silicon substrate;
bonding the composite substrate and the single crystal silicon substrate via a silicon oxide layer;
thinning the single crystal silicon substrate to be processed into a single crystal silicon layer;
placing a ring-shaped member so as to cover the single crystal silicon layer inward from an edge thereof;
growing an AlN film on the single crystal silicon layer; and
growing a GaN film or an AlGaN film, or both thereof on the AlN film.

Hereinafter, the present invention will be described in detail, but the present invention is not limited thereto.

The constitution of the inventive nitride semiconductor substrate is not particularly limited as long as it comprises a Ga-containing nitride semiconductor thin film formed on a substrate for film-forming in which a single crystal silicon layer is formed on a composite substrate in which at least a plurality of layers is bonded, wherein the nitride semiconductor substrate has a region where the Ga-containing nitride semiconductor thin film is not formed inward from an edge of the single crystal silicon layer being a growth surface of the nitride semiconductor thin film.

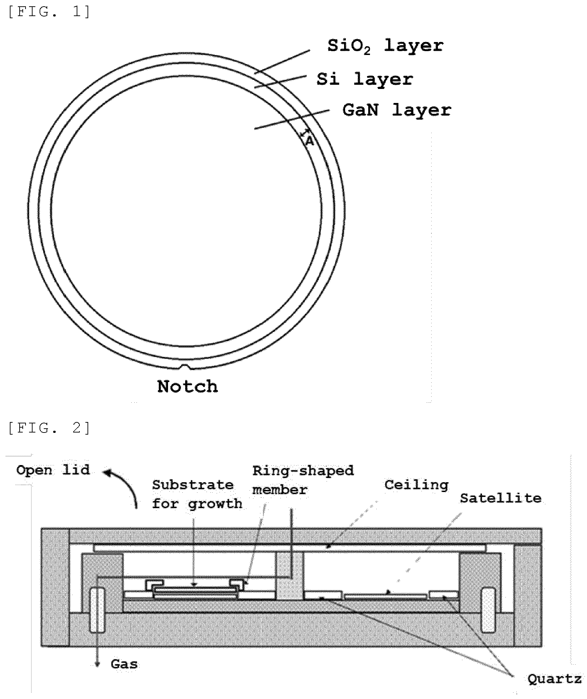

In the present invention, the nitride semiconductor thin film formed on the substrate for film-forming can have: an AlN film; and a GaN film or an AlGaN film, or a both thereof formed on the AlN film. For example, as illustrated in FIG. 2, an AlN film, an AlGaN film, and a GaN film can be epitaxially grown on the composite substrate for growing GaN (substrate for film-forming) by using a rotation-revolution type MOCVD reaction furnace.

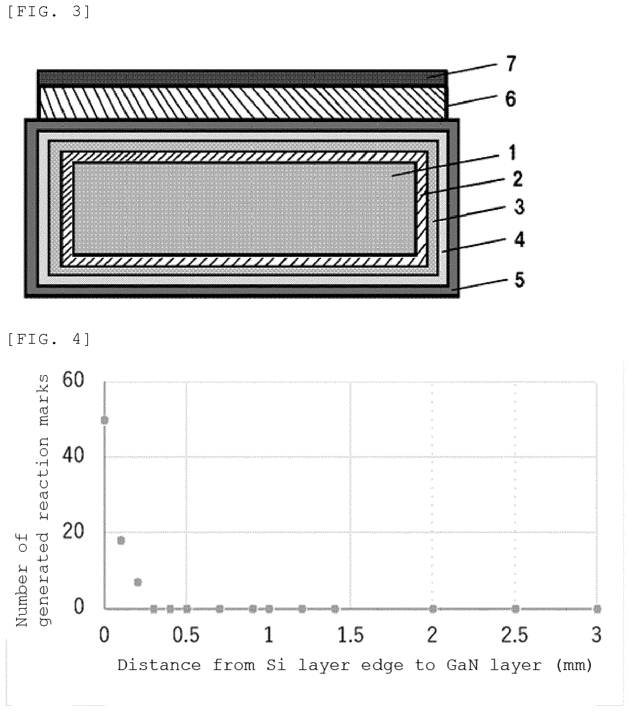

The composite substrate for growing GaN (substrate for film-forming) can be constituted with: the composite substrate having a polycrystalline ceramic core 1, a first adhesive layer 2 bonded to an entirety of the polycrystalline ceramic core, a conductive layer 3 bonded to an entirety of the first adhesive layer, a second adhesive layer 4 bonded to an entirety of the conductive layer, and a barrier layer 5 bonded to an entirety of the second adhesive layer; a silicon oxide layer 6 bonded only on one surface of the composite substrate; and a single crystal silicon layer 7 bonded to the silicon oxide layer, as illustrated in FIG. 3 for example.

Here, the polycrystalline ceramic core 1 can contain aluminum nitride, and sintered with a sintering auxiliary at a high temperature of, for example, 1800°C to preferably have a thickness of approximately 600 to 1150 um. Basically, the polycrystalline ceramic core 1 is formed with a thickness of the SEMI standard of the single crystal silicon substrate in many cases. The first adhesive layer 2 and the second adhesive layer 4 can be layers containing tetraethyl orthosilicate (TEOS) or silicon oxide (SiO₂), and deposited by, for example, an LPCVD process, a CVD process, etc. to preferably have a thickness of 100 nm. The conductive layer 3 can have a polysilicon layer, and deposited by, for example, an LPCVD process, etc. to preferably have a thickness of approximately 300 nm. This is a layer to impart the conductivity, and can be doped with boron (B), phosphorus (P), etc., for example. This conductive layer 3 may not be deposited in some cases.

The barrier layer 5 can contain silicon nitride, and deposited by, for example, an LPCVD process, etc. to preferably have a thickness of 400 nm to 500 nm. This is a layer to prevent diffusion and gas emission of elements present in the ceramic core, such as, for example, yttrium, yttrium oxide, oxygen, an metal impurity, and other trace elements, into an environment of a semiconductor processing chamber in the epitaxially growing process at a high temperature. The silicon oxide layer 6 is deposited by, for example, an LPCVD process, etc. to preferably have a thickness of approximately 1.5 um. The single crystal silicon layer 7 preferably has a thickness of 300 to 500 nm. This is a layer utilized as a growth surface for the epitaxial growth of the nitride semiconductor such as AlN and GaN, and can be bonded by laminating to the silicon oxide layer 6 by using a layer transferring process, for example. Thereafter, the single crystal silicon layer is preferably processed to be thinned. A method for thinning the single crystal silicon layer is not particularly limited, and conventional methods can be applied. For example, after the composite substrate and the single crystal silicon substrate are bonded via the silicon oxide layer, grinding, polishing, or etching can be performed from the surface of the single crystal silicon substrate to achieve the thinning. Alternatively, usable is a so-called ion-implanting peeling method in which an ion-implanting layer is formed on the single crystal silicon substrate and peeled with the ion-implanting layer after the bonding.

A thickness of each layer is not limited to the above value and all the layer are not necessarily present, but the nitride semiconductor substrate has at least the single crystal silicon layer and the composite substrate in which the plurality of the layers is bonded.

The composite substrate for growing GaN (substrate for film-forming) can be placed in, for example, a wafer pocket called as a satellite, as FIG. 2. For the epitaxial growth, trimethylaluminum (TMAl) as an Al source, TMGa as a Ga source, and NH₃ as a N source can be used, and are not limited thereto. The carrier gas can be N₂ and H₂, or any one thereof, and the process temperature is preferably, for example, approximately 900 to 1200°C.

In this time, it is acceptable that the composite substrate for growing GaN is placed in the satellite, and a ring-shaped member is placed on the composite substrate for growing GaN. The ring-shaped member is placed so that the single crystal silicon layer of the composite substrate for growing GaN covers a region of 0.3 mm or longer and shorter than 3 mm from the edge, for example. Thereafter, a lid is closed to perform the epitaxial growth. In the epitaxial layer in this time, the AlN film and the AlGaN film can be formed in this order in the growing direction from the substrate side, and thereafter the GaN film can be epitaxially growth, for example. The structure of the epitaxial layer is not limited thereto. The AlGaN film is not formed, or the AlN film is further formed after forming the AlGaN film in some cases. FIG. 1 illustrates a positional relationship between the single crystal silicon layer and the GaN layer in the case where the AlN film and the GaN film are formed in this order on the composite substrate for growing GaN. "A" in FIG. 1 represents a range not to grow the GaN film by placing the ring-shaped member. Here, FIG. 4 shows a relationship between a change in the width of A and a number of generated reaction marks. As understood from FIG. 4, no reaction mark is generated by setting the width of A to 0.3 mm or longer. The upper limit is preferably shorter than 3 mm with considering the device yield due to a reduction in the area of the GaN layer.

A material of the ring-shaped member is not particularly limited as long as it is a material durable against the reaction at a high temperature, but SiC, which causes little consumption and is almost permanently usable, is preferably used. This yields a cost merit.

### EXAMPLES

Hereinafter, the present invention will be specifically described by using Example and Comparative Example, but the present invention is not limited thereto.

### (Example)

Set in the satellite of the MOCVD apparatus illustrated in FIG. 2 was a composite substrate for growing GaN with 150 mm in diameter constituted with: a composite substrate having a polycrystalline ceramic core, a first adhesive layer (SiO₂) bonded to an entirety of the polycrystalline ceramic core, a conductive layer (poly-Si) bonded to an entirety of the first adhesive layer, a second adhesive layer (SiO₂) bonded to an entirety of the conductive layer, and a barrier layer (Si₃N₄) bonded to an entirety of the second adhesive layer; a silicon oxide layer bonded to only one surface of the composite substrate; and a single crystal silicon layer bonded to the silicon oxide layer. A ring-shaped member composed of SiC was placed on the composite substrate for growing GaN so that the single crystal silicon layer of the composite substrate for growing GaN covered a region with 0.3 mm inward from the edge.

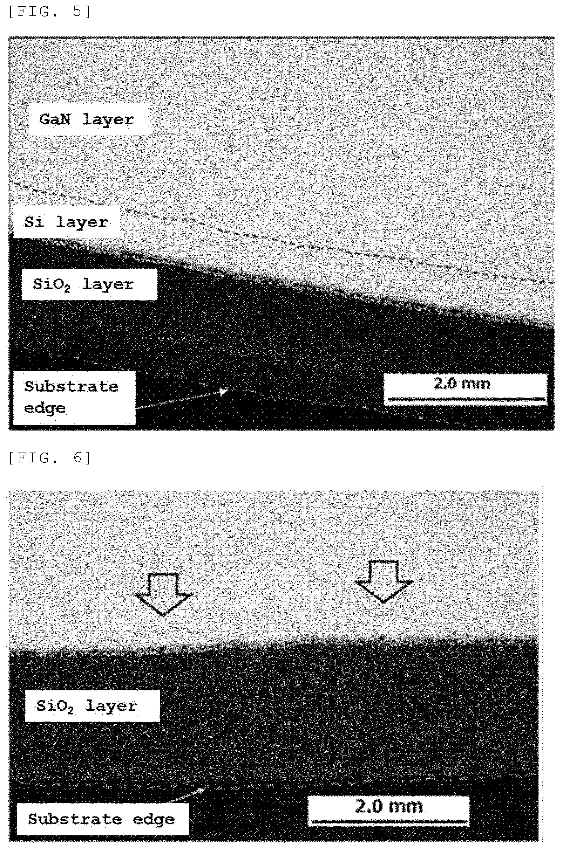

An AlN film with 100 nm in thickness was grown thereon. Thereafter, an AlGaN layer was grown with 150 nm. A GaN layer was grown thereon, and a total thickness of the epitaxial layer was 5 um. After the epitaxial growth was finished, a proximity of the edge of the Si layer of the composite substrate for growing GaN with the epitaxially grown GaN film was observed with an optical microscope to check a generation state of a reaction mark. FIG. 5 shows the result. As shown in FIG. 5, no reaction mark was generated.

### (Comparative Example)

An epitaxial growth was performed under the same condition as in Example except that the ring-shaped member was not placed. The generation state of a reaction mark on the periphery was checked in the same manner as in Example. FIG. 6 shows the result. As shown in FIG. 6, the generation of the reaction mark can be observed.

With comparing Example and Comparative Example, the inventive nitride semiconductor substrate can be a nitride semiconductor substrate with inhibited generation of the reaction mark.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A nitride semiconductor substrate, comprising a Ga-containing nitride semiconductor thin film formed on a substrate for film-forming in which a single crystal silicon layer is formed on a composite substrate in which a plurality of layers is bonded, wherein the nitride semiconductor substrate has a region where the Ga-containing nitride semiconductor thin film is not formed inward from an edge of the single crystal silicon layer being a growth surface of the nitride semiconductor thin film.

2. The nitride semiconductor substrate according to claim 1, wherein the region where the film is not formed is a region with 0.3 mm or longer and shorter than 3 mm inward from the edge of the single crystal silicon layer.

3. The nitride semiconductor substrate according to claim 1 or 2, wherein the single crystal silicon layer has a thickness of 300 to 500 nm.

4. The nitride semiconductor substrate according to any one of claims 1 to 3, wherein the nitride semiconductor thin film formed on the substrate for film-forming has: an AlN film; and a GaN film or an AlGaN film, or a both thereof formed on the AlN film.

5. The nitride semiconductor substrate according to any one of claims 1 to 4, wherein the substrate for film-forming is constituted with: the composite substrate having a polycrystalline ceramic core, a first adhesive layer bonded to an entirety of the polycrystalline ceramic core, a conductive layer bonded to an entirety of the first adhesive layer as necessary, a second adhesive layer bonded to an entirety of the conductive layer or to the entirety of the first adhesive layer, and a barrier layer bonded to an entirety of the second adhesive layer; a silicon oxide layer bonded only on one surface of the composite substrate; and the single crystal silicon layer bonded to the silicon oxide layer.

6. The nitride semiconductor substrate according to claim 5, wherein the polycrystalline ceramic core contains aluminum nitride.

7. The nitride semiconductor substrate according to claim 5 or 6, wherein the first adhesive layer and the second adhesive layer contain tetraethyl orthosilicate (TEOS) or silicon oxide (SiO₂), the conductive layer has a polysilicon layer, and the barrier layer contains silicon nitride.

8. A method for manufacturing a nitride semiconductor substrate, the method comprising steps of:
preparing at least a composite substrate in which a plurality of layers is bonded and a single crystal silicon substrate;
bonding the composite substrate and the single crystal silicon substrate via a silicon oxide layer;
thinning the single crystal silicon substrate to be processed into a single crystal silicon layer;
placing a ring-shaped member so as to cover the single crystal silicon layer inward from an edge thereof;
growing an AlN film on the single crystal silicon layer; and
growing a GaN film or an AlGaN film, or both thereof on the AlN film.

9. The method for manufacturing a nitride semiconductor substrate according to claim 8, wherein the composite substrate in which the plurality of the layers are bonded is a composite substrate having: a polycrystalline ceramic core; a first adhesive layer bonded to an entirety of the polycrystalline ceramic core; a conductive layer bonded to an entirety of the first adhesive layer as necessary; a second adhesive layer bonded to an entirety of the conductive layer or to the entirety of the first adhesive layer; and a barrier layer bonded to an entirety of the second adhesive layer.
